Europäisches Patentamt

European Patent Office

Office européen des brevets

(19)

(11) Publication number: **0 095 729**
**A2**

# EUROPEAN PATENT APPLICATION

(12)

(21) Application number: **83105198.2**

(22) Date of filing: **26.05.83**

(51) Int. Cl.³: **C 03 C 25/02**, C 23 C 11/00

(30) Priority: **28.05.82 US 382856**

(43) Date of publication of application: **07.12.83**
**Bulletin 83/49**

(84) Designated Contracting States: **DE FR GB IT**

(71) Applicant: **International Standard Electric Corporation,**
**320 Park Avenue, New York New York 10022 (US)**

(72) Inventor: **Biswas, Dipak Ranjan, 4330 Hollins Rd. N.**
**E. 10, Roanoke Virginia 24019 (US)**
Inventor: **Nath, Dilip Kumar, 2627 Mallard Dr. S.W.,**
**Roanoke Virginia 24019 (US)**

(74) Representative: **Graf, Georg Hugo, Dipl.-Ing. et al, c/o**
**Standard Elektrik Lorenz AG Patent- und Lizenzwesen**
**Postfach 300 929 Kurze Strasse 8,**
**D-7000 Stuttgart 30 (DE)**

(54) Hermetic coating by heterogeneous nucleation thermochemical deposition.

(57) An optical fiber which has just been drawn from an optical preform is provided with an external heremetic coating by using a heterogeneous nucleation thermochemical deposition technique. This technique involves passing the fiber through a reaction zone which contains a gaseous medium that includes a reactant which decomposes, or a mixture of reactants which chemically react, at a predetermined temperature to form the material of the coating. Only the fiber but not the gaseous medium surrounding the same is heated to the predetermined temperature, especially by directing radiation onto the exposed circumferential surface of the fiber, so that the decomposition or the chemical reaction takes place directly on the exposed surface of the fiber rather than in the gaseous medium, accompanied by simultaneous deposition of the coating material on the exposed surface of the fiber. The resulting fiber with heremetic coating can then be provided with an additional polymer coating layer.

D.R.Biswas-P.K.Nath 2-7

Hermetic Coating by heterogeneous Nucleation
Thermochemical Deposition

The invention relates to a method and an apparatus as set
forth in the preamble of claim 1 and claim 6, respectively.

One such method is known from DE-A1-31 13 883, by which
a hermetic coating is deposited on an optical fiber. This
conventional method, however, requires the manufacture
of an optical fiber having an electrically conducting surface, because the hermetic coating is deposited by employing
a CVD technique in which the fiber surface is heated
by an electric current.

It is the object of the invention to provide a method as
well as an apparatus for carrying out the method which is
also suitable for fibers having no electrically conducting
surface.

This object is achieved in the way as set forth in claims
1 and 6. Further embodiments of the invention are set forth
in the subclaims.

ZT/P1-Kg/R

24.05.1983

D.R.Biswas 2-7

The method of applying the hermetic coating according to the invention will hereafter be referred to as hetergeneous nucleation thermochemical deposition (HNTD). This is a process of coating in which the deposits are produced by hetergeneous chemical reactions directly at the heated substrate surface rather than in the atmosphere surrounding the fiber. A volatile compound of the element or substance to be deposited is vaporized, and the vapor thermally decomposed or reacted with other vapors at the heated substrate surface to yield non-volatile reaction products as a coating onto the substrate. The HNTD process can be carried out at a low temperature or at a high temperature depending upon the coating and the reactants.

The HNTD method is distinctively different from some kind of chemical vapor deposition, which is a homogeneous chemical reaction process in which the reaction products are mainly formed in the vapor phase.

In chemical vapor deposition, the material of the coating is formed in a gaseous state, either by releasing the material of the coating from a single gaseous reactant at a temperature needed for releasing such a material, or by reacting at least two gaseous reactants with one another at the required reaction temperature.

In that type of chemical vapor deposition characterized by a homogeneous chemical reaction process the material of the coating forms particles in the gaseous medium in which the release or the chemical formation of such material takes place. These particles are then deposited on the exposed surface of the fiber.

D.R.Biswas 2-7

This approach has an inherent disadvantage in that the CVD reaction products (mostly solid particles) can interact with the substrate surface, that is, with the exposed surface of the fiber, to produce surface damage during the deposition process. Experience has shown that CVD usually produces large grains or growth cones which can produce substantial flaws in the fiber to cause degradation in strength of the fiber, by creating fissures or microcracks in the material of the fiber. Thus, when this method of coating is used, the strength of unit length of the fiber is reduced below that which the unit length had immediately after the drawing of the fiber or the fiber core and prior to the application of the hermetic coating to the core in the chemical vapor deposition process. While this degradation in strength may not affect each unit length, it occurs often enough for the overall strength of the substantial length of the hermetically coated fiber to be considerably reduced relative to the strength which the material of the fiber had immediately after drawing. This, of course, is very disadvantageous.

In contrast, the HNTD process produces a fine grained structure directly at the substrate and avoids the growth cones completely. There is no interaction of solid particles with the substrate surface to produce surface damage.

The coating materials
          - Should have good adhesion or bonding with
            the substrate material
          - Should have a thermal expansion coefficient
            comparable to that of the substrate material

D.R.Biswas 2-7

to minimize thermal stresses and
- Should be corrosion resistant to the environment in which the fiber is intended to be used.

Preferred coating materials are metals/alloys, glass and ceramics. The substrate materials are glass, ceramics, and metals. The raw gaseous materials are mainly metal halides, such as silicon halides, oxyhalides, hydrides, carbonyls, organometallics and metal organics along with other reactant gases and carrier gases.

Above-mentioned and other features and objects of this invention will become more apparent by reference to the following description taken in conjunction with the ac-

D.R.Biswas 2-7

companying drawing, in which:

Fig. 1      is a diagrammatic side elevational view of
            an apparatus according to the present invention
            for producing a coated optical fiber;

Fig. 2      is a diagrammatic sectional view of the apparatus according to the present invention
            taken on line II-II or Fig. 1, on an enlarged
            scale; and

Fig. 3      is a substantially enlarged transverse sectional view of a coated fiber as produced by
            the apparatus of Fig. 1.

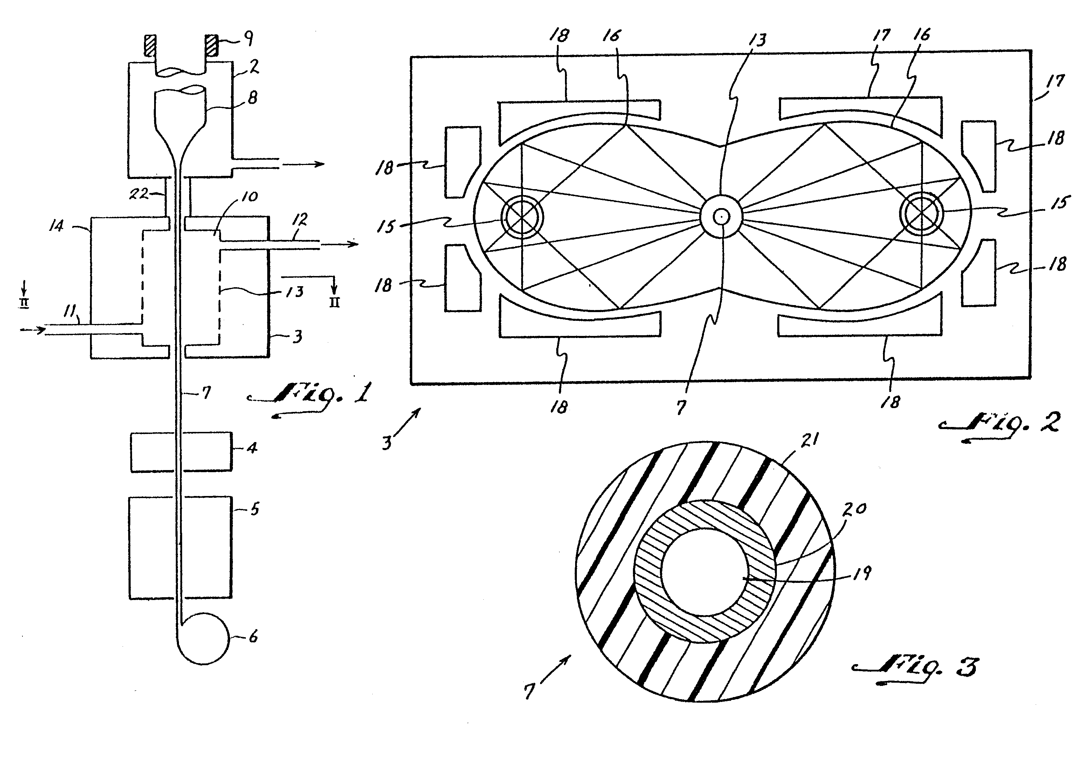

The apparatus 1 shown in Fig. 1 includes, as its main components, a fiber preform draw furnace 2, a reactor 3, a
polymer coater 4, a curing oven 5, and a drawing arrangement 6. The drawing arrangement 6 is diagrammatically il-
lustrated as a spool. The drawing arrangement 6 draws, in
a conventional manner, a fiber 7 from a preform 8 which is
mounted in a chuck 9 and which extends into the fiber preform draw furnace 2. The chuck 9 may rotate the preform 8
during the drawing operation, if necessary or advantageous.
The portion of the preform 8 which is received in the draw
furnace 2 is heated in a conventional manner, such as by
hot gases, an oxyhydrogen flame, a plasma flame, or by a
radation. The particular method which is used for heating
the preform 8 is of no consequence in the context of the
present invention.

What is important is that, immediately after leaving the
draw furnace 2 and in any event before the freshly drawn

D.R.Biswas 2-7

exposed surface of the fiber 7 has suffered any damage, the fiber 7 enters the interior of the reactor 3. The reactor 3 bounds an internal chamber 10 into which a reactant gas is admitted through an inlet port 11 and from which the spent reactant gas is discharged through an outlet port 12. As mentioned before, and as will be discussed in detail later on, the reactant gas consists of or contains at least one reactant or substance which, when heated to predetermined temperature, releases the material of the hermetic coating which is to be applied to the exterior of the fiber 7 in the reaction chamber 10. It may be seen that the reactant gas passes through the chamber 10 in counterflow to the advancement of the fiber 7 through the chamber 10. The reaction chamber 10 is circumferentially surrounded by a transparent window 13. A heating assembly 14 is arranged at the exterior of the transparent window 13 and is operative for directing radiation, especially infrared radiation, against the exposed surface of the fiber 7 as the latter passes through the reaction chamber 10. The transparent window 13 need not be transparent to all kinds of radiation, but it must be transparent to the radiation which is used for heating the external exposed surface of the fiber 7. Further details of the construction of the heating assembly 14 will be discussed below in connection with Fig. 2.

Referring still to Fig. 1 it may be seen that the fiber 7, which has acquired hermetic coating in the reaction chamber 10 is conducted through the interior of the polymer coater 4 after emerging from the reactor 3. The polymer coater 4 is of a conventional construction so that no details thereof need be discussed here. Suffice it to say that at least one additional layer of coating, especially of polymer

D.R.Biswas 2-7

coating, is applied on top of the aforementioned hermetic coating produced in the reaction chamber 10 of the reactor 3. After this polymer coating has been applied, the fiber 7 passes through the curing oven 5 where the polymer coating is cured, especially by applying heat thereto, to give such a coating the desired properties. Even the construction of the curing oven 5 is conventional and will not be described here. Finally, the now coated fiber 7 reaches the drawing arrangement or spool 6 to be wound thereon for at least temporary storage purposes.

Further details of the reactor 3 are shown in Fig. 2. The heating assembly 14 is shown to include two elongated heating elements or sources 15 which extend substantially parallel to the direction of advancement of the fiber 7. The elongated heating sources 15 are situated at the respective foci of associated substantially elliptical mirrors 16, while the fiber 7 passes through the other focus. The reactor 3 includes a housing 17, and the mirrors 16 may be directly applied or connected to the internal surface of the housing 17 which bounds a cavity for the heating sources 15. The heating sources 15 emit radiation, especially infrared radiation, which is either directly aimed at or reflected by the mirrors 16 toward the transparent window or wall portion 13 and through the same onto or toward the drawn fiber 7, as diagramatically illustrated by respective lines indicating the trajectories of selected rays of the radiation. The housing 17 includes a plurality of compartments or ducts 18 through which a cooling medium, such as water, is circulated to cool the housing 17 at the region of the mirrors 16.

0095729

D.R.Biswas 2-7

As may be seen in Fig. 3, the fiber 7 in its final condition existing after it has emerged from the curing oven 5 (see Fig. 1) includes a core 19 of an optic material, such as glass or the like, a hermetic layer 20 produced by the HNTD process of the present invention in the reactor 3, and an outer coating 21 of organic material which is produced in the coating arrangement 4 and cured in the curing arrangement 5.

In conventional fiber drawing, when the fiber is drawn from a solid preform, it passes through a polymer coater to preserve the fiber pristine surface and for handling ease. Thus, the hermetic coating by HNTD process has to be carried out in between the drawing zone 2 and the polymer coater 4. With the help of the heating assembly 14, only the fiber 7 gets heated to a desired temperature for the heterogeneous chemical reaction for deposition within the reaction chamber or zone 10. This reaction temperature is referred to as the "heterogeneous chemical reaction temperature." The temperature at the wall of the transparent window 13 will be lower than that of the fiber surface. Therefore, no chemical reaction products will be deposited on the inside of the wall surface. Low temperature and high temperature reaction conditions for hermetic coating onto a glass fiber (on line) are shown in the following Table 1. Only a few examples of metals and ceramic coating materials are listed in Table 1.

D.R.Biswas 2-7

## TABLE 1
### Reacting Conditions of HNTD Materials

| Coating Material | Reactant(s) | Type of Reaction | Reaction Temperature $^{o}C$ | Reaction Enviroments |
|---|---|---|---|---|
| Al | Triisobutyl Aluminum and Isobutylene | Decomposition | 260 | |
| Ni | Nickel Carbonyl | Decomposition | 200 | $NH_3$, $CO_2$, $H_2$ and $H_2S$ |
| Si | Silicon Tetrachloride and Hydrogen | Hydrogen Reduction | 1200 | $H_2$ |
| Ti | Titanium Iodide | Decomposition | 1200-1400 | Ar, He |
| $Si_3N_4$ | Silane and Ammonia | Vapor Phase Reaction | 600-1000 | $H_2$ |
| $SnO_2$ | Tin Tetrachloride and Oxygen | Oxidation | 873 | |
| BN | Diborane and Ammonia | Vapor Phase Reaction | 400-700 | |
| $TiO_2$ | Titanium Tetrachloride and Oxygen | Oxidation | >1000 | |

The vapor of the volatile metal compounds constituting the reactants is generated by evaporation. This evaporation may be accomplished either by heating a volatile compound or by passing a non-reactive gas over or through the volatile compound and reacting into metal immediately

D.R.Biswas 2-7

at the surface of the fiber 7 with simultaneous deposit. Any volatile byproducts must be transported away through the exhaust 12.

Deposition parameters are gas flow rates, pressure and temperature. An increase in concentration of reactive gas or substrate temperature increases the deposition rates. Increasing substrate temperatures or decreasing reactive gas concentration increases the crystallinity of the film or coating 20. Impurities affect film growth by modifying the nucleation rate and by causing structural defects. Carbon contamination, for example, during the deposition of silicon may cause stacking faults and whiskers and impede step motion.

The film should firmly adhere to the glass and should not produce any surface damage to the surface of the fiber. The thermal expansion mismatch between the metal such as silicons, film or coating 20 and the glass fiber core 19 should not produce sufficient stresses to cause failure at the film-fiber interface.

As mentioned before, the freshly drawn fiber 7 must be provided with the hermetic coating 20 prior to suffering any appreciable damage due to environmental influences. To achieve this, the draw furnace 2 and the reactor 3 may either be situated directly above one another or form a structural unit by having a common housing or, as shown in Fig. 1, a tubular shielding element 22 may be interposed between the draw furnace 2 and the reactor 3. The fiber 7 then passes through the interior of the shielding element 22 and is thus protected from environmental influences. A particular advantage of this latter approach

D.R.Biswas 2-7

is that the shielding element 22 may be provided with a diameter control window to permit constant or intermittent supervision of the drawing operation.

INTERNATIONAL STANDARD ELECTRIC
CORPORATION, NEW YORK

D.R.Biswas 2-7

Claims

1.  A method of producing an optical fiber having a hermetic coating on its surface and one ore more organic
coatings on the hermetic coating, c h a r a c t e r i z e d
i n   that the hermetic coating is applied in the following
steps: passing the fiber through a gaseous medium con-
taining at least one reactant capable of undergoing a
chemical conversion into the material of the coating when
heated to a predetermined temperature; and heating the
optical fiber at least at its exposed surface at least to
the predetermined temperature for the chemical conversion
into and simultaneous deposition of the material of the
coating to take place directly on the exposed surface.

2.  The method as defined in claim 1, characterized in
that the hermetic coating is applied to the optical fiber
immediately after the drawing of the fiber from an optical
preform.

3.  The method as defined in claim 1, characterized in
that the passing and heating steps are conducted at the
same region.

4.  The method as defined in claim 1 or 2, characterized
in that it further comprises the step of circulating the

D.R.Biswas 2-7

gaseous medium around the heated exposed surface of the fiber.

5. The method as defined in any one of claims 1 to 4, characterized in that the heating step includes directing radiation against the exposed surface.

6. An apparatus for applying a hermetic coating to an exposed surface of an optical fiber, characterized in that it comprises means for defining a reaction zone; means for maintaining in the reaction zone a body of a gaseous medium containing at least one reactant capable of undergoing a chemical conversion into the material of the coating when heated to a predetermined temperature; and means (15, 16) for heating the optical fiber (7) at least at its exposed surface at least to the predetermined temperature for the chemical conversion into and simultaneous deposition of the material of the coating to take place directly on the exposed surface.

7. The apparatus as defined in claim 6, characterized in that, the heating means includes means (15, 16) for directing radiation onto the exposed surface of the fiber.

8. The apparatus as defined in claim 6, characterized in that the defining means (10) includes at least one wall portion (13) which circumferentially surrounds said reaction zone and which is transparent to said radiation; and that the directing means includes at least one source (15) of said radiation disposed externally of said wall portion and aimed through the latter at the exposed

D.R.Biswas 2-7

surface of the fiber passing through said reaction zone.

9. The apparatus as defined in claim 8, characterized in that the directing means further includes at least one reflecting member (16) partially surrounding said source and operative for reflecting the radiation emitted by said source (15) and reaching said reflecting member toward said wall portion and through the same onto the exposed surface of the fiber (7) passing through said reaction zone.

10. The apparatus as defined in any one of claims 7 to 9, characterized in that the directing means includes at least one elongated radiation source (15) extending substantially parallel to the fiber (7).

Fig. 1

Fig. 2

Fig. 3